(19) Europäisches Patentamt
European Patent Office
Office européen des brevets

(11) **EP 3 676 425 B1**

(12) **EUROPÄISCHE PATENTSCHRIFT**

(45) Veröffentlichungstag und Bekanntmachung des Hinweises auf die Patenterteilung:
**04.10.2023 Patentblatt 2023/40**

(21) Anmeldenummer: **18762067.9**

(22) Anmeldetag: **28.08.2018**

(51) Internationale Patentklassifikation (IPC):
**C30B 15/20** (2006.01)   **C30B 29/06** (2006.01)
**C30B 15/22** (2006.01)

(52) Gemeinsame Patentklassifikation (CPC):
**C30B 29/06; C30B 15/20; C30B 15/203;
C30B 15/206; C30B 15/22**

(86) Internationale Anmeldenummer:
**PCT/EP2018/073101**

(87) Internationale Veröffentlichungsnummer:
**WO 2019/042979 (07.03.2019 Gazette 2019/10)**

(54) **VERFAHREN ZUR HERSTELLUNG EINES EINKRISTALLS AUS SILIZIUM MIT <100>-ORIENTIERUNG, DER MIT DOTIERSTOFF VOM N-TYP DOTIERT IST**

METHOD FOR PRODUCING A SILICON SINGLE CRYSTAL WITH <100>- ORIENTATION, WHICH IS DOPED WITH DOPANT OF N-TYPE

PROCÉDÉ POUR PRODUIRE UN MONOCRISTAL DE SILICIUM AYANT UNE ORIENTATION <100>, QUI EST DOPÉ AVEC UN DOPANT DE TYPE N

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.09.2017 DE 102017215332**

(43) Veröffentlichungstag der Anmeldung:
**08.07.2020 Patentblatt 2020/28**

(73) Patentinhaber: **Siltronic AG
81677 München (DE)**

(72) Erfinder:
• **RAMING, Georg
84367 Tann (DE)**
• **STOCKMEIER, Ludwig
01187 Dresden (DE)**
• **FRIEDRICH, Jochen
90542 Eckental Eckenhaid (DE)**
• **DANIEL, Matthias
09599 Freiberg (DE)**
• **MILLER, Alfred
84547 Emmerting (DE)**

(74) Vertreter: **Staudacher, Wolfgang
Siltronic AG
Intellectual Property -LP 244
Johannes-Hess-Str. 24
84489 Burghausen (DE)**

(56) Entgegenhaltungen:
**EP-A1- 1 158 075     WO-A1-2016/103987**

**Beschreibung**

Gegenstand der Erfindung ist ein Verfahren zur Herstellung eines Einkristalls aus Silizium mit <100>-Orientierung, der mit Dotierstoff vom n-Typ dotiert ist. Von Einkristallen dieser Art werden Halbleiterscheiben abgetrennt, die als Substrate zur Herstellung von elektronischen Bauelementen für Leistungsanwendungen, beispielsweise Power MOSFETs, verwendet werden. Die benötigten Einkristalle werden üblicherweise gemäß der CZ-Methode aus einer Schmelze gezogen, die in einem Tiegel bereitgestellt wird.

Stand der Technik / Probleme

Aus EP 1 158 075 A1 ist beispielsweise bekannt, dass es von Vorteil ist, den Anfangskonus des Einkristalls derart zu ziehen, dass dessen Form vergleichsweise spitz ist. Diese Maßnahme reduziert die Häufigkeit von Ereignissen, bei denen Versetzungen entstehen, auf Grund derer einkristallines Kristallwachstum nicht mehr möglich ist und das Ziehen abgebrochen werden muss.

Es wurde auch der Einfluss untersucht, den konstitutionelle Unterkühlung (constitutional supercooling) auf die Versetzungsbildung hat (J.Friedrich et al., ACTA PHYSICA POLONICA A No.2, Vol.124 (2013), pp. 219-226), und aus den Ergebnissen der Untersuchung geschlossen, dass es von Vorteil ist, einen höheren Temperaturgradienten zu etablieren, die Ziehgeschwindigkeit zu verringern und den konvektiven Transport von Schmelze zu erhöhen.

In US 2015/0275392 A1 wird davon berichtet, dass häufig Oberflächen-Facetten (surface facets) auf dem Anfangskonus auftauchen, bevor dort Versetzungen entstehen.

WO 2016/103 987 A1 beschäftigt sich mit einem Verfahren zur Herstellung eines Einkristalls gemäß der CZ-Methode, das einen Einkristall zugänglich macht, dessen spezifischer elektrischer Widerstand in einem zylindrischen Abschnitt vergleichsweise niedrig ist. Das Verfahren beinhaltet den Beginn des Ziehens des Anfangskonus, solange der Quotient H/R zwischen 0,4 und 0,78 beträgt, wobei H die Tiefe der Schmelze an der tiefsten Stelle und R den Radius der Schmelze bezeichnen.

Die Erfinder der vorliegenden Erfindung haben sich die Aufgabe gestellt, aufzuzeigen, wie die Häufigkeit der Bildung von Versetzungen, die den Abbruch des Ziehens erforderlich machen, weiter herabgesetzt werden kann.

Gegenstand der Erfindung ist deshalb ein Verfahren zur Herstellung eines Einkristalls aus Silizium mit <100>-Orientierung, umfassend

  das Dotieren einer Schmelze mit Dotierstoff vom n-Typ;
  das Ziehen eines Anfangskonus (1), eines zylindrischen Abschnitts und eines Endkonus des Einkristalls nach der CZ-Methode;
  das Ziehen des Anfangskonus mit einem Kristallwinkel κ von nicht weniger als 20° und nicht mehr als 30° in einem mittleren Abschnitt des Anfangskonus (1), dessen Länge nicht weniger als 50 % einer Länge des Anfangskonus (1) beträgt, wobei Schwankungen des Kristallwinkels κ mittels Winkelregelung auf nicht mehr als 0,01°/s begrenzt werden; das Ziehen des zylindrischen Abschnitts des Einkristalls mit einer Ziehgeschwindigkeit, die nicht mehr als 75 % einer Grenzziehgeschwindigkeit beträgt, bei deren Überschreitung ein Verformen des Einkristalls eine Fortsetzung des Ziehens verhindert; und das aktive Kühlen des Einkristalls..

Der über das Verfahren zugängliche Einkristall ist mit Phosphor, Arsen oder Antimon dotiert oder mit einer Mischung von einem oder mehreren dieser Dotierstoffe. Der spezifische elektrische Widerstand (resistivity) beträgt im Fall des Dotierens mit Phosphor vorzugsweise nicht mehr als 1,2 mΩcm, im Fall des Dotierens mit Arsen vorzugsweise nicht mehr als 3 mΩcm und im Fall des Dotierens mit Antimon vorzugsweise nicht mehr als 30 mΩcm.

Der über das Verfahren zugängliche Einkristall hat im zylindrischen Abschnitt einen Durchmesser von vorzugsweise nicht weniger als 150 mm oder nicht weniger als 200 mm, besonders bevorzugt einen Durchmesser von nicht weniger als 300 mm.

Charakteristische Merkmale des über das Verfahren zugänglichen Einkristalls sind der Kristallwinkel im mittleren Abschnitt des Anfangskonus und die Länge von Kanten-Facetten (edge facets), insbesondere die Länge derjenigen im Bereich des Anfangskonus. Der Anfangskonus lässt sich in drei Abschnitte gliedern, nämlich in einen ersten Abschnitt, im Verlauf dessen der Kristallwinkel auf den Kristallwinkel des zweiten, mittleren Abschnitts ansteigt und einen dritten Abschnitt, im Verlauf dessen der Kristallwinkel auf den Kristallwinkel des zylindrischen Abschnitts des Einkristalls abnimmt.

Der Kristallwinkel ist der Winkel zwischen der <100>-Richtung, in die der Einkristall wächst, und einer Tangente, die am Rand des Einkristalls anliegt. Kanten-Facetten sind Facetten entlang von {111}-Ebenen, die sich vom Rand des Einkristalls in einem Grenzwinkel (boundary angle) zur erwähnten Tangente ins Innere des Einkristalls erstrecken.

Im mittleren Abschnitt des Anfangskonus, dessen Länge nicht weniger als 50 %, vorzugsweise nicht weniger als 70 % und besonders bevorzugt nicht weniger als 90 % der Länge des Anfangskonus beträgt, ist der Kristallwinkel ist nicht kleiner als 20° und nicht größer als 30°. Der dritte Abschnitt des Anfangskonus (Umbiegen) hat eine Länge im unteren einstelligen Prozentbereich, beispielsweise 2%. Der erste Abschnitt des Anfangskonus des Einkristalls hat eine Länge, die praktisch dem Rest entspricht.

Die Erfinder haben ermittelt, dass Versetzungen ihren Ursprung an Kanten-Facetten haben und dass die Länge der Kanten-Facetten, insbesondere die Länge derjenigen im Anfangskonus, ein kritischer Parameter ist, von dem die Häufigkeit der Bildung von Versetzungen abhängt. Sie kommen zu dem Schluss, dass die Länge der Kanten-Facetten nicht mehr als 700 μm im Anfangs-konus und nicht mehr als 700 μm, vorzugsweise nicht mehr als 300 μm im zylindrischen Abschnitt des Einkristalls betragen soll, um die gestellte Aufgabe zu erfüllen.

Zur Bestimmung der Länge der Kanten-Facetten wird der Einkristall in {110}-Ebenen parallel zur Wachstumsrichtung des Einkristalls geschnitten und zwar so, dass sich eine Ziehkante (ridge) des Einkristalls in der Mitte der abgetrennten kachelförmigen Probe (slab) befindet. Die Probe wird dann auf einer Seitenfläche bis zur Tiefe der Ziehkante geschliffen, poliert und vorzugsweise mittels präferentieller Defektätze nach Secco (preferential etching) geätzt. Die Länge der Kanten-Facetten kann anschließend durch Inspektion mit einem optischen Mikroskop bestimmt werden. Dabei ist zu berücksichtigen, dass mit der Messebene auch das Zentrum der Ziehkante getroffen wurde (größte messbare Facettenlänge), ansonsten wird die Facettenlänge fälschlicherweise zu klein gemessen.

Die Länge der Kanten-Facetten lässt sich über den Temperaturgradient im wachsenden Einkristall beeinflussen. Sie ist umso kürzer, je größer der Temperaturgradient entlang der Ausdehnungsrichtung der Kanten-Facetten ist. Es ist daher bevorzugt darauf hinzuwirken, dass die Phasengrenze zwischen dem wachsenden Einkristall und der Schmelze eine Form annimmt, aufgrund derer dieser Temperaturgradient möglichst groß wird. Das ist dann der Fall, wenn der Krümmungswinkel zwischen der Richtung der Ziehachse und der Richtung entgegen der Wachstumsrichtung des Einkristalls im Bereich des Rands des Einkristalls 0° oder kleiner als 0°, besonders bevorzugt -35,5° ist. Der Bereich des Rands des Einkristalls ist der Bereich, der sich vom Rand bis zu einer Länge von 0,1 mm radial in den Einkristall erstreckt.

Bevorzugt ist, dass die Phasengrenze beim Ziehen des mittleren Abschnitts und des dritten Abschnitts des Anfangskonus eine Form hat, die, entgegen der Ziehachse betrachtet, konkav gekrümmt, w-förmig oder eben ist. Eine solche Form ist auch beim Ziehen des zylindrischen Abschnitts des Einkristalls anzustreben, wobei eine konkav gekrümmte Phasengrenze besonders bevorzugt ist. In diesem Fall ist der Krümmungswinkel zwischen der Richtung der Ziehachse und der Richtung entgegen der Wachstumsrichtung des Einkristalls im Bereich des Rands des Einkristalls vorzugsweise kleiner als 0°.

Besonders bevorzugt ist das Ziehen des zylindrischen Abschnitts des Einkristalls mit einer Ziehgeschwindigkeit, die nicht mehr als 65% der Grenzziehgeschwindigkeit beträgt.

Vor dem Ziehen des Einkristalls wird die Schmelze mit Phosphor, Arsen oder Antimon dotiert oder mit einer Mischung von einem oder mehreren dieser Dotierstoffe. Vorzugsweise wird eine Menge an Dotierstoff zur Verfügung gestellt, die ausreicht, um einen Einkristall zu ziehen, dessen spezifischer elektrische Widerstand im zylindrischen Abschnitt des Einkristalls im Fall des Dotierens mit Phosphor vorzugsweise nicht mehr als 1,2 mΩcm, im Fall des Dotierens mit Arsen vorzugsweise nicht mehr als 3 mΩcm und im Fall des Dotierens mit Antimon vorzugsweise nicht mehr als 30 mΩcm beträgt.

Die Erfinder haben festgestellt, dass das Längenwachstum der Kanten-Facetten besonders vom Kristallwinkel und dem Temperaturgradienten an der Phasengrenze zwischen dem wachsenden Einkristall und der Schmelze abhängt. Um das Ziel zu erreichen, das Längenwachstum von Kanten-Facetten im gewünschten Ausmaß zu begrenzen, sollte der Kristallwinkel nicht größer als 30° sein, und der Bereich in der Nähe der Phasengrenze aktiv gekühlt werden, vorzugsweise mittels einer Kühlvorrichtung, durch die Wasser zum Kühlen strömt, insbesondere auch bereits während des Ziehens des Anfangskonus. Die Abkühlgeschwindigkeit beträgt im Temperaturbereich vom Schmelzpunkt (1410 °C) von Silizium bis 1000 °C vorzugsweise nicht weniger als 2 K/min beim Ziehen des zylindrischen Abschnitts eines Einkristalls aus Silizium mit einem Durchmesser von mindestens 300 mm.

Diese Maßnahmen reichen für sich genommen noch nicht aus, da das System sehr empfindlich auf Schwankungen des Kristallwinkels und Temperaturschwankungen im Bereich der Phasengrenze reagiert. Es ist daher weiterhin günstig, das Ziehen des mittleren Abschnitts des Anfangskonus des Einkristalls mittels Winkelregelung zu begleiten und die Ziehgeschwindigkeit beim Ziehen des zylindrischen Abschnitts des Einkristalls deutlich zu begrenzen.

Während des Ziehens des mittleren Abschnitts des Anfangskonus bis zum Zeitpunkt, zu dem mit dem Umbiegen begonnen wird, wird vorzugsweise eine Regelung auf den Kristallwinkel eingesetzt. Eine solche Regelung ist beispielsweise in WO 00/60145 A1 beschrieben und verwendet den Kristallwinkel als Führungsgröße. Mit Umbiegen wird die Übergangsphase bezeichnet, während der der Kristallwinkel des Anfangskonus auf den Kristallwinkel des zylindrischen Abschnitts des Einkristalls zurückgeführt wird.

Weiterhin ist bevorzugt, während des Umbiegens den Einkristall ohne Winkelregelung nach einem vorgefassten Plan (gesteuert) zu ziehen. Die Steuerung berücksichtigt die Ziehgeschwindigkeit und die Heizleistung der Tiegelheizung und gegebenenfalls die Heizleistungen einer oder mehrerer Zusatzheizungen zum Erhitzen der Schmelze von oben. Die Ziehgeschwindigkeit sollte während des Umbiegens nicht mehr als 1,5 mm/min betragen. Vorzugsweise wird die Ziehgeschwindigkeit beim Umbiegen auf diesen Wert gesetzt. An Stelle einer Erhöhung der Ziehgeschwindigkeit über diese Grenze hinaus kann die Heizleistung der Tiegelheizung und gegebenenfalls die Heizleistung der einen oder mehreren Zusatzheizungen erhöht werden.

Die Ziehgeschwindigkeit sollte während des Ziehens des zylindrischen Abschnitts des Einkristalls nicht mehr betragen, als das 0,75-fache, besonders bevorzugt nicht mehr als das 0,65-fache einer Grenzziehgeschwindigkeit. Die Grenzziehgeschwindigkeit ist die maximal mögliche Geschwindigkeit, mit der der Einkristall in der verwendeten Vorrichtung gezogen werden kann, ohne dass sich der Einkristall so sehr verformt, dass das Fortsetzen des Ziehens unmöglich wird. Weicht die Position der Achse durch die Mitte des Einkristalls von einer vorgesehenen Position um mehr als 5 mm ab, kann eine Verformung des Einkristalls angenommen werden, bei deren Vorliegen das Ziehen nicht mehr fortgesetzt werden kann. Die Begrenzung der Ziehgeschwindigkeit dient dem Zweck, die Temperaturschwankungen im Bereich der Phasengrenze zu begrenzen.

Wie bereits erwähnt, ist es von Vorteil dafür zu sorgen, dass die Phasengrenze während des Ziehens des zylindrischen Abschnitts des Einkristalls eine Form hat, die konkav gekrümmt ist. Vorzugsweise beträgt der Krümmungswinkel im Bereich des Rands des Einkristalls weniger als 0°. Zu diesem Zweck sollte das Verhältnis der Drehgeschwindigkeit des Einkristalls und der Drehgeschwindigkeit des Tiegels vorzugsweise nicht weniger als 2 betragen und/oder die Schmelze einem horizontalem Magnetfeld oder einem CUSP-Magnetfeld von vorzugsweise nicht weniger als 2500 Gauss ausgesetzt werden.

Nachfolgend wird die Erfindung mit Bezugnahme auf Zeichnungen weiter erläutert.

**Kurzbeschreibung der Figuren**

**Fig. 1** dient der Begriffserläuterung und zeigt in schematischer Darstellungsweise einen Längsschnitt durch die Mitte eines Anfangskonus.

**Fig. 2** zeigt schematisch einen Teilschnitt in Wachstumsrichtung durch einen wachsenden Anfangskonus.

**Fig. 3** zeigt ein Diagramm, in dem der Temperaturgradient entlang der Facette Gf über dem Krümmungswinkel θ aufgetragen ist.

**Fig. 4** zeigt einen Teil einer Aufnahme einer Probe nach Präparation bei Inspektion in einem optischen Mikroskop.

**Fig. 5** und **Fig. 6** zeigen den Verlauf des Kristallwinkels und der Länge von Kanten-Facetten von einem Einkristall, der erfindungsgemäß hergestellt wurde.

**Liste der verwendeten Bezugszeichen**

1 Anfangskonus
2 Kanten-Facette
3 Oberflächen-Facette
4 Meniskus
5 Phasengrenze

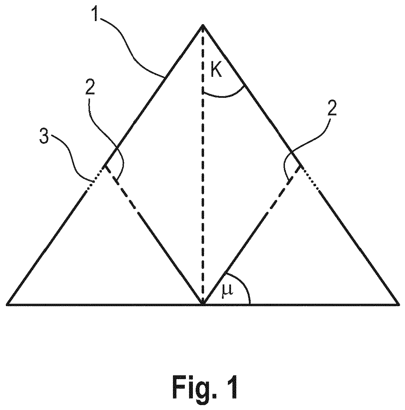

Ein Anfangskonus 1 mit einem Kristallwinkel κ, wie er in Fig.1 schematisch dargestellt ist, weist typischerweise Kanten-Facetten 2 und gegebenenfalls Oberflächen-Facetten 3 auf. Die Kanten-Facetten 2 erstrecken sich vom Rand des Anfangskonus 1 entlang von {111}-Ebenen ins Innere. Der Schnittwinkel μ zwischen einer {111}-Ebene und einer Ebene senkrecht zur Wachstumsrichtung eines Einkristalls mit <100>-Orientierung hat den festen Wert von 54,7°.

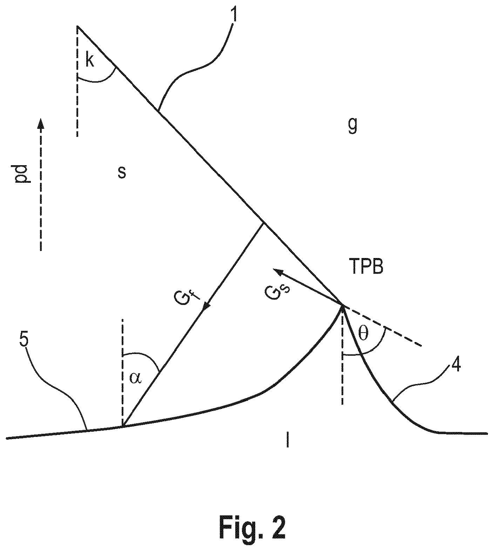

Fig.2 zeigt einen Anfangskonus 1 eines <100>-orientierten Einkristalls aus Silizium, der an einer Phasengrenze 5 zu einer Schmelze wächst. Die Phasengrenze 5 erstreckt sich zum Rand des Einkristalls bis zu einer Dreiphasengrenze TPB, wo am oberen Ende eines Meniskus 4 der Schmelze die flüssige Phase l, gebildet von der Schmelze, die feste Phase s, gebildet vom Einkristall, und die Gasphase g, gebildet von einer umgebenden Atmosphäre, aufeinandertreffen. Der Verlauf der Phasengrenze 5 repräsentiert näherungsweise auch den Verlauf einer Isotherme. Kanten-Facetten erstrecken sich entlang einer Richtung, die mit der Richtung der Ziehachse pd einen Winkel α von 35,3° bildet. Der Temperaturgradient Gf in Ausdehnungsrichtung einer Kanten-Facette sollte möglichst groß sein, damit die Länge der Kanten-Facette möglichst klein wird. Dementsprechend sollte der Krümmungswinkel θ zwischen der Richtung der Ziehachse und der Richtung des Temperaturgradienten $G_s$ am Rand des Einkristalls 0° oder kleiner als 0° sein, besonders bevorzugt -35,3°. Der Temperaturgradient $G_s$ erstreckt sich von der Phasengrenze 5 im rechten Winkel in den Einkristall und hat damit die Richtung entgegen der Wachstumsrichtung des Einkristalls. Die Temperaturgradienten Gf und $G_s$ sowie der Krümmungswinkel θ stehen über die folgende Gleichung miteinander in Beziehung:

$$G_s = \cos(35{,}3° + θ) \times G_f$$

Die Phasengrenze 5 hat, abweichend von der Darstellung gemäß Fig.2, möglichst eine Form, die, entgegen der Richtung der Ziehachse betrachtet, konkav gekrümmt, w-förmig, nahezu eben oder eben ist. Der Kristallwinkel κ beträgt in einem mittleren Abschnitt des Anfangskonus, dessen Länge nicht weniger als 50 % einer Länge des Anfangskonus beträgt, nicht weniger als 20° und nicht mehr als 30°.

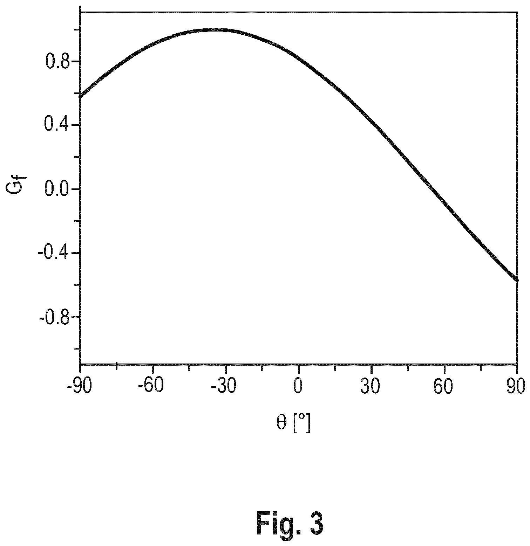

In Fig.3 ist der Temperaturgradient Gf über den Krümmungswinkel θ aufgetragen. Die Temperaturgradienten Gf und $G_S$ erreichen bei θ = -35,3° ein Maximum.

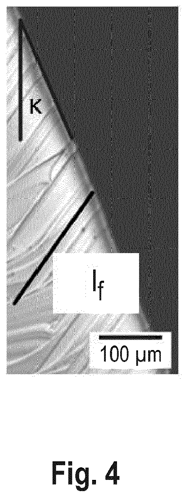

Eine Aufnahme gemäß Fig.4 kann zur Bestimmung der Länge von Kanten-Facetten verwendet werden. Sie zeigt einen Teil des mittleren Abschnitts eines Anfangskonus. Zusätzlich eingezeichnet sind der Kristallwinkel κ und die Länge $l_f$ einer Kanten-Facette.

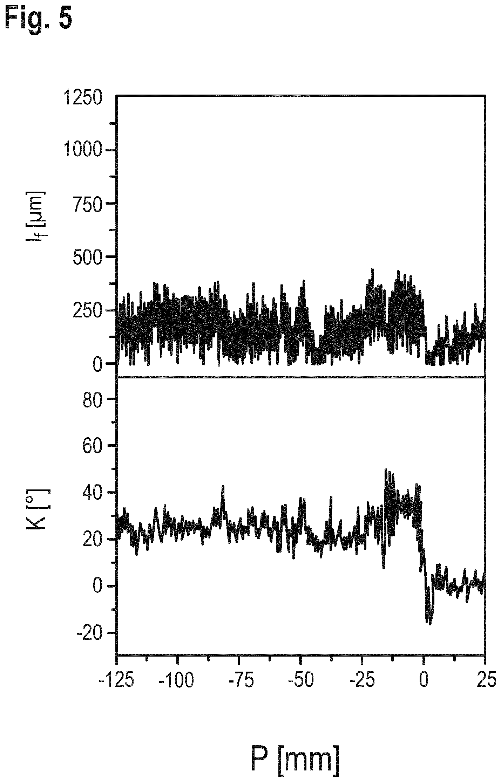

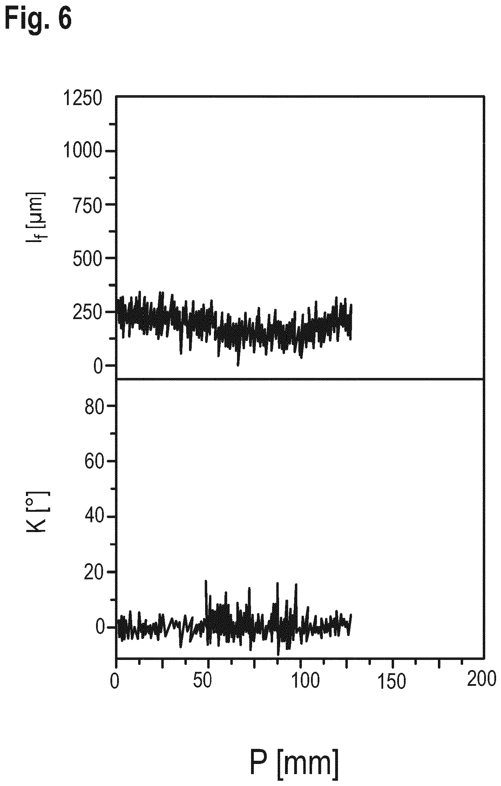

Fig. 5 und Fig.6 zeigen von einem Einkristall, der erfindungsgemäß hergestellt wurde, den Verlauf des Kristallwinkels κ und der Länge $l_f$ von Kanten-Facetten vom Beginn des Ziehens des mittleren Abschnitts des Anfangskonus bei Position P = -125 mm bis zum Ziehen der ersten 25 mm des zylindrischen Abschnitts des Einkristalls (Fig.5) und den entsprechenden Verlauf vom Beginn des Ziehens des zylindrischen Abschnitts (P = 0 mm) bis zum Ziehen der ersten 125 mm des zylindrischen Abschnitts des Einkristalls (Fig.6).

## Patentansprüche

1. Verfahren zur Herstellung eines Einkristalls aus Silizium mit <100>-Orientierung, umfassend

    das Dotieren einer Schmelze mit Dotierstoff vom n-Typ;
    das Ziehen eines Anfangskonus (1) mit einem Kristallwinkel κ, dem Winkel zwischen der <100>-Richtung, in die der Einkristall wächst, und einer Tangente, die am Rand des Einkristalls anliegt, eines zylindrischen Abschnitts und eines Endkonus des Einkristalls nach der CZ-Methode;
    das Ziehen des Anfangskonus mit dem Kristallwinkel κ von nicht weniger als 20° und nicht mehr als 30° in einem mittleren Abschnitt des Anfangskonus (1), dessen Länge nicht weniger als 50 % einer Länge des Anfangskonus (1) beträgt, wobei Schwankungen des Kristallwinkels κ mittels Winkelregelung auf nicht mehr als 0,01 °/s begrenzt werden; das Ziehen des zylindrischen Abschnitts des Einkristalls mit einer Ziehgeschwindigkeit, die nicht mehr als 75 % einer Grenzziehgeschwindigkeit beträgt, bei deren Überschreitung ein Verformen des Einkristalls eine Fortsetzung des Ziehens verhindert; und das aktive Kühlen des Einkristalls im Bereich in der Nähe der Phasengrenze (5) zwischen dem wachsenden Einkristall und der Schmelze.

2. Verfahren nach Anspruch 1, des Weiteren umfassend das Ziehen des Einkristalls in einem Übergangsbereich zwischen dem Anfangskonus (1) und dem zylindrischen Abschnitt mit einer Ziehgeschwindigkeit von nicht mehr als 1,5 mm/min.

3. Verfahren nach Anspruch 1 oder Anspruch 2, wobei das Kühlen des Einkristalls mittels eines wassergekühlten Kühlers erfolgt.

4. Verfahren nach einem der Ansprüche 1 bis 3, des Weiteren umfassend das Abtrennen der Halbleiterscheiben vom zylindrischen Abschnitt des Einkristalls.

## Claims

1. A method for producing a single crystal of silicon with <100> orientation, comprising the doping of a melt with n-type dopant;

    drawing an initial cone (1) having a crystal angle κ, the angle between the <100> direction in which the single crystal grows and a tangent line which is adjacent to the edge of the single crystal, a cylindrical section, and an end cone of the single crystal by the CZ method; drawing the initial cone with the crystal angle κ of not less than 20° and not more than 30° in a central portion of the initial cone (1) whose length is not less than 50% of a length of the initial cone (1), wherein fluctuations of the crystal angle κ are limited to not more than 0.01 °/s by angle control; pulling the cylindrical portion of the single crystal at a pulling speed which is not more than 75% of a limit pulling speed beyond which deformation of the single crystal prevents continuation of pulling; and active cooling of the single crystal in the region near the phase boundary (5) between the growing single crystal and the melt.

2. The method of claim 1, further comprising drawing the single crystal in a transition region between the initial cone (1) and the cylindrical portion at a drawing speed of not more than 1.5 mm/min.

3. Method according to claim 1 or claim 2, wherein the cooling of the single crystal is carried out by means of a water-cooled cooler.

4. A method according to any one of claims 1 to 3, further comprising the separation of the semiconductor wafers from the cylindrical section of the single crystal.

## Revendications

1. Procédé de fabrication d'un monocristal de silicium d'orientation <100>,

    comprenant le dopage d'une masse fondue avec un dopant de type n ;
    le tirage d'un cône initial (1) ayant un angle cris-

tallin $\kappa$, l'angle entre la direction <100> dans laquelle le monocristal croît et une tangente qui s'appuie sur le bord du monocristal, d'une partie cylindrique et d'un cône final du monocristal selon la méthode CZ ;

le tirage du cône initial avec l'angle cristallin $\kappa$ non inférieur à 20° et non supérieur à 30° dans une partie centrale du cône initial (1) dont la longueur n'est pas inférieure à 50 % d'une longueur du cône initial (1), les variations de l'angle cristallin $\kappa$ étant limitées à pas plus de 0,01°/s au moyen d'une commande angulaire ; le tirage de la partie cylindrique du monocristal à une vitesse de tirage qui n'est pas supérieure à 75 % d'une vitesse de tirage limite au-delà de laquelle une déformation du monocristal empêche la poursuite du tirage ; et

le refroidissement actif du monocristal dans la zone située à proximité de la limite de phase (5) entre le monocristal en croissance et la masse fondue.

2. Procédé selon la revendication 1, comprenant en outre le tirage du monocristal dans une zone de transition entre le cône initial (1) et la partie cylindrique à une vitesse de tirage ne dépassant pas 1,5 mm/min.

3. Procédé selon la revendication 1 ou la revendication 2, dans lequel le refroidissement du monocristal est effectué au moyen d'un refroidisseur refroidi par eau.

4. Procédé selon l'une quelconque des revendications 1 à 3, comprenant en outre la séparation des plaquettes semi-conductrices de la partie cylindrique du monocristal.

**Fig. 1**

**Fig. 2**

**Fig. 3**

## Fig. 4

## Fig. 5

## Fig. 6

**EP 3 676 425 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1158075 A1
- US 20150275392 A1
- WO 2016103987 A1
- WO 0060145 A1

**In der Beschreibung aufgeführte Nicht-Patentliteratur**

- **J.FRIEDRICH et al.** *ACTA PHYSICA POLONICA A,* 2013, vol. 124 (2), 219-226